# EUROPEAN PATENT APPLICATION

(11) **EP 4 521 130 A1**
(43) Date of publication of application: **12.03.2025**
(21) Application number: 24767017.7
(22) Date of filing: 29.02.2024
(51) Int. Cl.: G01R 31/392, G01R 31/367, H01M 10/42, H01M 10/48, H02J 7/00

(54) **DIAGNOSIS DEVICE FOR ON-VEHICLE SECONDARY BATTERY**

(30) Priority: 08.03.2023 JP 2023035708
(71) Applicant: Toyo System Co., Ltd., Iwaki-shi, Fukushima 972-8316 (JP)
(72) Inventor: HASEGAWA Takamasa, Iwaki-shi, Fukushima 972-8316 (JP); SHOJI Masahiro, Iwaki-shi, Fukushima 972-8316 (JP); SHOJI Hideki, Iwaki-shi, Fukushima 972-8316 (JP)
(74) Representative: Dr. Schön, Neymeyr & Partner Patentanwälte mbB
(86) International application number: PCT/JP2024/007559
(87) International publication number: WO 2024/185647

(57) **Abstract**

Provided is a diagnosis device for an on-vehicle secondary battery capable of diagnosing a degradation state of the on-vehicle secondary battery even when direct information for identifying the type and configuration of the secondary battery cannot be obtained. The diagnosis device for the on-vehicle secondary battery includes a storage element that stores a secondary battery database in which the model of a vehicle and the nominal battery capacity of the secondary battery are associated with the model of the secondary battery, and correlation data indicative of a correlation between voltage, current, and temperature values for each model of the secondary battery, and the degradation state of the secondary battery, wherein an acquisition processing element refers to the secondary battery database to acquire the model of the secondary battery based on the model of the vehicle and a value of the nominal battery capacity of the secondary battery mounted on the vehicle, and acquires voltage, current, and temperature values while the secondary battery is charging or discharging, and a determination processing element determines the degradation state of the secondary battery using the correlation data corresponding to the model of the secondary battery based on the voltage, current, and temperature values of the secondary battery.

## Description

### Technical Field

The present invention relates to a device for diagnosing the degradation state of an on-vehicle secondary battery.

### Background Art

A secondary battery state estimation device for estimating secondary battery deterioration information using information on the voltage and current of a secondary battery is proposed (see Patent Literature 1).

### Citation List

### Patent Literature

Patent Literature 1: Japanese Patent Application Laid-Open No. 2021-183927

### Summary of Invention

### Technical Problem

There is a need to diagnose the degree of deterioration of a secondary battery for driving, which is mounted on an electric car or the like (on-vehicle secondary battery), for example, during regular vehicle inspection or when selling the electric car or the like as a used car. Since there is a certain correlation between the degradation state of the secondary battery, and the voltage value and the current value of the secondary battery, the degradation state of the on-vehicle secondary battery can be diagnosed based on the voltage value and the current value of the secondary battery.

However, since the correlation between the degradation state, and the voltage value and the current value of the secondary battery varies depending on the secondary battery type, the secondary battery configuration, and the like, it is required to acquire information on the secondary battery type, the secondary battery configuration, and the like (for example, information on the battery model) together when diagnosing the degradation state of the secondary battery based on the voltage value and the current value of the secondary battery.

There is no problem if the information that identifies the type, configuration, and the like of the on-vehicle secondary battery can be obtained when diagnosing the degradation state of the on-vehicle secondary battery, but there may be a case where these pieces of information cannot be obtained. To deal with such a case, it is required a technique capable of identifying the type and configuration of the on-vehicle secondary battery even when direct information for identifying the type and configuration of the battery cannot be obtained.

However, in the technique of Patent Literature 1, since it is not considered how to identify these pieces of information when the direct information for identifying the type and configuration of the secondary battery cannot be obtained, the degradation state of the secondary battery cannot be diagnosed based on the voltage value and the current value of the secondary battery when these pieces of information cannot be obtained.

Therefore, it is an object of the present invention to provide a diagnosis device for an on-vehicle secondary battery capable of diagnosing the degradation state of the on-vehicle secondary battery even when direct information for identifying the type and configuration of the on-vehicle secondary battery cannot be obtained.

### Solution to Problem

A diagnosis device for an on-vehicle secondary battery of the present invention, including:
an acquisition processing element that acquires data on a vehicle and a secondary battery mounted on the vehicle;
a storage element that stores a secondary battery database in which data for identifying a model of the vehicle and data on a value of a nominal battery capacity of the secondary battery are associated with data on a model of the secondary battery, and correlation data indicative of a correlation between voltage, current, and temperature values for each secondary battery model, and a degradation state of the secondary battery; and
a determination processing element that determines the degradation state of the secondary battery mounted on the vehicle, wherein
the acquisition processing element acquires data for identifying the model of the vehicle and data on the value of the nominal battery capacity of the secondary battery mounted on the vehicle,
the acquisition processing element refers to the secondary battery database to acquire the data on the model of the secondary battery mounted on the vehicle based on the acquired data for identifying the model of the vehicle, and the acquired data on the value of the nominal battery capacity of the secondary battery mounted on the vehicle,
the acquisition processing element acquires data on the voltage, current, and temperature values of the secondary battery while the secondary battery mounted on the vehicle is charging or discharging, and
the determination processing element determines the degradation state of the secondary battery mounted on the vehicle using the correlation data corresponding to the model of the secondary battery based on the data on the model of the secondary battery mounted on the vehicle and the data on the voltage, current, and temperature values of the secondary battery acquired by the acquisition processing element.

It has been found through research by the inventors that the model of the secondary battery can be identified if the model of the vehicle and the nominal battery capacity of the secondary battery mounted on the vehicle are found.

According to the present invention, the secondary battery database in which the data for identifying the model of the vehicle and the data on the value of the nominal battery capacity of the secondary battery are associated with the data on the model of the secondary battery is stored in the storage element. Then, the acquisition processing element acquires data for identifying the model of the vehicle and data on the value of the nominal battery capacity of the secondary battery mounted on the vehicle, and refers to the secondary battery database to acquire the data on the model of the secondary battery mounted on the vehicle based on the data for identifying the model of the vehicle, and the data on the value of the nominal battery capacity of the secondary battery mounted on the vehicle.

Then, the determination processing element determines the degradation state of the secondary battery mounted on the vehicle using the correlation data corresponding to the model of the secondary battery based on the acquired data on the model of the secondary battery mounted on the vehicle and the acquired data on the voltage, current, and temperature values of the secondary battery.

Thus, according to the present invention, since the model of the secondary battery can be identified based on the model of the vehicle and the nominal battery capacity of the secondary battery mounted on the vehicle, the degradation state of the on-vehicle secondary battery can be diagnosed even when direct information for identifying the type and configuration of the secondary battery cannot be obtained.

### Brief Description of Drawings

FIG, 1 is a block diagram illustrating an example of an overall picture of a diagnosis device for an on-vehicle secondary battery of the present invention.
FIG. 2 is a table illustrating an example of data content used for processing by the diagnosis device for the on-vehicle secondary battery of the present invention.
FIG. 3 is a flowchart illustrating an example of processing details of the diagnosis device for the on-vehicle secondary battery of the present invention.

### Description of Embodiment

### <Configuration of Diagnosis Device for On-vehicle Secondary Battery>

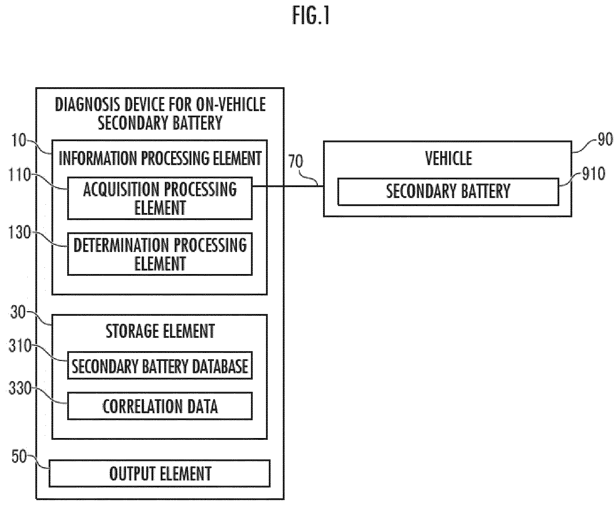

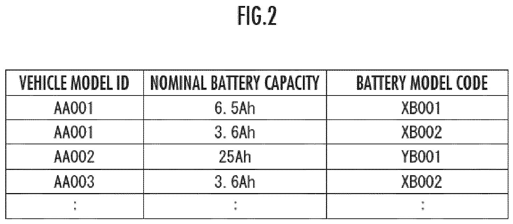

Referring first to FIG. 1 and FIG. 2, the configuration of a diagnosis device for an on-vehicle secondary battery of the present embodiment will be described. As illustrated in FIG. 1, the diagnosis device for the on-vehicle secondary battery of the present embodiment is configured to include an information processing element 10, a storage element 30, and an output element 50.

The information processing element 10 is a so-called processor composed of an arithmetic processing unit like a CPU (Central Processing Unit), a memory, I/O (Input/Output) devices, and the like.

The information processing element 10 reads and executes a predetermined program to function, for example, as an acquisition processing element 110 and a determination processing element 130.

The acquisition processing element 110 acquires data on a vehicle 90 and a secondary battery 910 mounted on the vehicle.

The determination processing element 130 determines the degradation state of the secondary battery 910 mounted on the vehicle 90. For example, if the dischargeable amount of the secondary battery 910 that is unused and fully charged is set to 100%, the degradation state of the secondary battery 910 will be an estimated value of the percentage of a dischargeable amount when the secondary battery 910 is fully charged at the time of data acquisition.

The degradation state of the secondary battery 910 may also be an estimated value obtained by subtracting the dischargeable amount of the secondary battery 910 when fully charged at the time of data acquisition from the dischargeable amount of the secondary battery 910 that is unused and fully charged, and dividing the subtracted value by the dischargeable amount of the secondary battery 910 that is unused and fully charged.

Further, the degradation state of the secondary battery 910 may be an estimated value obtained by subtracting the dischargeable amount of the secondary battery 910 when fully charged at the time of data acquisition from the dischargeable amount of the secondary battery 910 that is unused and fully charged, and expressing the subtracted value in Ah units (or Wh units), or an estimated value obtained by expressing, in Ah units, the dischargeable amount of the secondary battery 910 when fully charged at the time of data acquisition.

The storage element 30 is configured, for example, by storage devices such as a ROM (Read Only Memory), a RAM (Random Access Memory), an HDD (Hard Disk Drive), and the like.

In the storage element 30, processing results of the diagnosis device for the on-vehicle secondary battery and information used for the processing in addition to a secondary battery database 310 and correlation data 330 are stored.

The secondary battery database 310 is a database in which data for identifying the model of the vehicle and data on the value of the nominal battery capacity of the secondary battery are associated with data on the secondary battery model. As illustrated in FIG. 2, for example, in the secondary battery database 310, a vehicle model ID as the data for identifying the model of the vehicle, and a nominal battery capacity as the data on the value of the nominal battery capacity of the secondary battery, and a battery model code as the data on the secondary battery model corresponding to the combination of the vehicle ID and the nominal battery capacity are stored in association with one another. As illustrated in FIG. 2, even when the vehicle model ID is the same, if the nominal battery capacities are different, different battery model codes will be associated therewith. Further, if the same secondary battery is mounted on different vehicle models, the same battery model code is associated with the different vehicle models.

Note that an example in which the data on the value of the nominal battery capacity of the secondary battery is stored in units of Ah is illustrated in FIG. 2, but the data on the value of the nominal battery capacity of the secondary battery may also be stored using any other unit such as Wh instead of or in addition to Ah.

Alternatively, any other information effective for identifying the secondary battery model may further be contained in the secondary battery database 310 in addition to the vehicle model ID and the nominal battery capacity, and stored in the secondary battery database 310 together with the vehicle model ID and the nominal battery capacity in association with the battery model code.

The correlation data 330 is data indicative of a correlation between the voltage, current, and temperature values for each secondary battery, and the degradation state of the secondary battery. For example, the correlation data 330 is a function, a calculation formula, or the like for calculating the degradation state of the secondary battery 910 mounted on the vehicle 90 using the voltage value, the current value, and the temperature value of the secondary battery 910 as input values.

For example, the correlation data 330 may also be a learned model subjected to machine learning of the correlation between the voltage value, current value, and temperature value of the secondary battery, and the degradation state of the secondary battery using, as learning data, voltage values, current values, and temperature values of multiple secondary batteries, and the degradation state of each secondary battery when the values are acquired, which is a model to output the degradation state of the secondary battery 910 using the voltage value, the current value, and the temperature value of the secondary battery 910 as input values.

Further, for example, the correlation data 330 may be a correspondence table in which information on a combination of the voltage value, the current value, and the temperature value of the secondary battery 910 (or a combination of ranges of the values such as "a range of ∘ or more and a range of less than Δ) is associated with the degradation state of the secondary battery 910 mounted on the vehicle 90.

Note that the function, calculation formula, the model, or the correspondence table may also be associated with each battery model code one by one, or a single function, calculation formula, or model may further be associated with two or more battery model codes.

The output element 50 is, for example, a display, a printer, or a speaker to output information to the diagnosis device for the on-vehicle secondary battery.

Alternatively, the diagnosis device for on-vehicle secondary battery may further include, for example, an unillustrated input unit. The input unit is, for example, a keyboard or a touch panel, a mouse or any other pointing device to accept user input.

The vehicle 90 is an electric car, a PHV car, or a HV car driven by the secondary battery 910.

The secondary battery 910 may be any of various secondary batteries capable of being used to drive the vehicle such as a lead-acid battery, a nickel-cadmium battery, a nickel-metal hydride battery, or a lithium-ion battery.

### <Processing Overview>

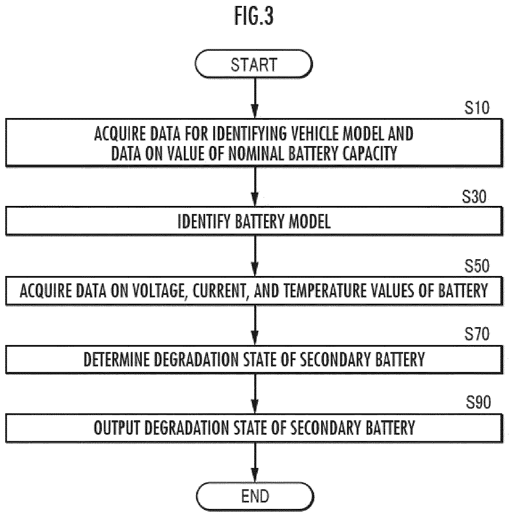

Referring next to FIG. 3, processing details of the diagnosis device for the on-vehicle secondary battery of the present embodiment will be described. For example, after power is turned on, when the diagnosis device for the on-vehicle secondary battery of the present embodiment is connected to an information output terminal or the like through a cable 70 to acquire CAN data from an OBD (On Board Diagnostics) provided in the vehicle 90, the diagnosis device for the on-vehicle secondary battery starts the processing.

When the diagnosis device for the on-vehicle secondary battery starts the processing, the acquisition processing element 110 first acquires data for identifying the model of the vehicle 90 and data on the value of the nominal battery capacity of the secondary battery 910 mounted on the vehicle (FIG. 3/S10). The data for identifying the vehicle model is, for example, a Vehicle Identification Number (VIN). The nominal battery capacity of the secondary battery 910 is a design discharge capacity when fully charged (a so-called nominal capacity) specified by the manufacturer of the secondary battery. Alternatively, for example, a design discharge capacity when the secondary battery is discharged from the fully charged state under specified conditions (a so-called rated capacity) may also be used as the nominal battery capacity.

The acquisition processing element 110 acquires the data for identifying the model of the vehicle 90, for example, from the Vehicle Identification Number (VIN). In other words, for example, in the storage element 30, one or more pieces of data, each indicating from what number to what number in the digits of the Vehicle Identification Number (VIN) is information capable of identifying the vehicle mode, are recorded, and the acquisition processing element 110 refers to the data to acquire, from the Vehicle Identification Number (VIN), candidates for the information for identifying the vehicle model and to perform a search on a field of the vehicle model ID of the secondary battery database 310 stored in the storage element 30 using the candidates for the information, and when an applicable vehicle model ID exists, the acquisition processing element 110 recognizes that the vehicle model ID concerned is the data for identifying the model of the vehicle 90 and acquires the recognized data as the data for identifying the model of the vehicle 90.

For example, the acquisition processing element 110 is connected to the information output terminal or the like to acquire CAN data from the OBD provided in the vehicle 90 through the cable 70 or the like in order to acquire, from the vehicle 90, the data for identifying the model of the vehicle 90 and the data on the value of the nominal battery capacity of the secondary battery 910 mounted on the vehicle. Alternatively, for example, the acquisition processing element 110 may also acquire the data from the vehicle 90 via wireless communication. Further, for example, the acquisition processing element 110 may acquire the data for identifying the model of the vehicle 90 and the data on the value of the nominal battery capacity of the secondary battery 910 mounted on the vehicle by accepting manual input by an operator through the input unit.

Next, the acquisition processing element 110 refers to the secondary battery database 310 to acquire the data on the model of the secondary battery 910 mounted on the vehicle 90 based on the data for identifying the model of the vehicle 90 and the data on the value of the nominal battery capacity of the secondary battery 910 mounted on the vehicle 90 acquired in S10 (FIG. 3/S30).

Specifically, the acquisition processing element 110 uses a combination of the data for identifying the model of the vehicle 90 and the data on the value of the nominal battery capacity of the secondary battery 910 mounted on the vehicle 90 contained in the CAN data acquired in S10 to perform searches on the field of the vehicle model ID and the field of the nominal battery capacity of the secondary battery database 310 stored in the storage element 30, and when a combination of the vehicle model ID and the nominal battery capacity exists, the acquisition processing element 110 recognizes the battery model code corresponding to the combination as the data of the model of the secondary battery 910 mounted on the vehicle 90, and acquires the recognized data as data on the model of the secondary battery 910 mounted on the vehicle 90.

Subsequently, the acquisition processing element 110 acquires data on the voltage, current, and temperature values while the secondary battery 910 mounted on the vehicle 90 is charging or discharging (FIG. 3/S50). In other words, for example, the acquisition processing element 110 acquires the CAN data from the vehicle 90 in a state of charging or discharging to acquire data on the voltage, current, and temperature values of the secondary battery 910 while charging or discharging, which are contained in the CAN data.

Alternatively, for example, the acquisition processing element 110 may also acquire the data on the voltage, current, and temperature values of the secondary battery 910 through a voltmeter, an ammeter, and a thermometer, which are provided separately and not illustrated. Further, for example, the acquisition processing element 110 may acquire the data on the voltage, current, and temperature values of the secondary battery 910 by accepting manual input by the operator through the input unit.

Next, the determination processing element 130 determines the degradation state of the secondary battery 910 mounted on the vehicle 90 using the correlation data 330 corresponding to the model of the secondary battery 910 based on the data on the model of the secondary battery 910 mounted on the vehicle 90, and the data on the voltage, current, and temperature values of the secondary battery 910 acquired by the acquisition processing element 110 (FIG. 3/S70).

More specifically, the determination processing element 130 first recognizes the data on the model of the secondary battery 910 mounted on the vehicle 90 (battery model code) acquired by the acquisition processing element 110. Then, the determination processing element 130 acquires, from the storage element 30, the function, the calculation formula, the model, or the correspondence table as the correlation data 330 corresponding to the model of the secondary battery 910.

Subsequently, the determination processing element 130 recognizes the data on the voltage, current and temperature values of the secondary battery 910 acquired by the acquisition processing element 110 to acquire a value of the degradation state of the secondary battery 910 as an output value using the recognized information as input values to the function, the calculation formula, or the model as the correlation data 330, or to acquire a value of the degradation state of the secondary battery 910 associated with a set of the data on the voltage, current, and temperature values of the secondary battery 910 by referring to the correspondence table.

The determination processing element 130 determines the value of the degradation state of the secondary battery 910 acquired in that way as the degradation state of the secondary battery 910 mounted on the vehicle 90.

Then, the determination processing element 130 outputs, to the output element 50, the above-determined degradation state of the secondary battery 910 mounted on the vehicle 90 (FIG. 3/S90), and the series of processes is ended.

For example, the determination processing element 130 displays the degradation state of the secondary battery 910 on a display device such as a display as the output element 50. Alternatively, the determination processing element 130 may output the degradation state of the secondary battery 910 by printing it through a printing device such as a printer, or may output the degradation state of the secondary battery 910 by playing a sound to notify the value of the degradation state of the secondary battery 910 through a sound device such as a speaker.

While one example of the embodiment of the diagnosis device for the on-vehicle secondary battery of the present invention is described above, the present invention is not limited to this example. Various changes may be made as long as the effects of the present invention can be attained.

In other words, for example, the embodiment in which the secondary battery database 310 and the correlation data 330 are stored in the storage element 30 of the diagnosis device for the on-vehicle secondary battery is described above, but the present invention is not limited thereto. For example, either one or both of the secondary battery database 310 and the correlation data 330 may also be stored in another unillustrated computer. In this case, the acquisition processing element 110 may be configured to use the other computer as part of the storage element 30 to refer to the either one or both of the secondary battery database 310 and the correlation data 330 stored in the other computer via a wired or wireless communication line in order to perform the above-described processing.

### Description of Reference Numerals

10... information processing element, 30.. storage element, 50... output element, 90...vehicle, 110... acquisition processing element, 130... determination processing element, 310.. secondary battery database, 330...correlation data, 910... secondary battery.

## Claims

1. A diagnosis device for an on-vehicle secondary battery, comprising:
an acquisition processing element that acquires data on a vehicle and a secondary battery mounted on the vehicle;
a storage element that stores a secondary battery database in which data for identifying a model of the vehicle and data on a value of a nominal battery capacity of the secondary battery are associated with data on a model of the secondary battery, and correlation data indicative of a correlation between voltage, current, and temperature values for each secondary battery model, and a degradation state of the secondary battery; and
a determination processing element that determines the degradation state of the secondary battery mounted on the vehicle, wherein
the acquisition processing element acquires data for identifying the model of the vehicle and data on the value of the nominal battery capacity of the secondary battery mounted on the vehicle,
the acquisition processing element refers to the secondary battery database to acquire the data on the model of the secondary battery mounted on the vehicle based on the acquired data for identifying the model of the vehicle, and the acquired data on the value of the nominal battery capacity of the secondary battery mounted on the vehicle,
the acquisition processing element acquires data on the voltage, current, and temperature values of the secondary battery while the secondary battery mounted on the vehicle is charging or discharging, and
the determination processing element determines the degradation state of the secondary battery mounted on the vehicle using the correlation data corresponding to the model of the secondary battery based on the data on the model of the secondary battery mounted on the vehicle and the data on the voltage, current, and temperature values of the secondary battery acquired by the acquisition processing element.
